# EUROPEAN PATENT SPECIFICATION

(11) **EP 1 685 598 B1**
(45) Date of publication and mention of the grant of the patent: **06.06.2012**
(21) Application number: 04780607.0
(22) Date of filing: 10.08.2004
(51) Int. Cl.: H01L 21/00, B65G 49/07, B65G 37/02

(54) **AUTOMATED MATERIAL HANDLING SYSTEM**
AUTOMATISIERTES MATERIALHANDHABUNGSSYSTEM
SYSTEME DE MANIPULATION AUTOMATIQUE DE MATERIAU

(30) Priority: 30.10.2003 US 697528
(43) Date of publication of application: 02.08.2006
(73) Proprietor: Murata Machinery, Ltd., 3 Minami Ochiai-cho, Kisshoin Minami-ku, Kyoto-shi, Kyoto (JP)
(72) Inventor: SULLIVAN, Robert, P., Wilmington, MA 01887 (US); HARIS, Clint, Lunenburg, MA 01462 (US); BUFANO, Michael, L., Belmont, MA 02478 (US); FRIEDMAN, Gerald, New Ipswich, NH 03971 (US); HOFMEISTER, Christopher, Hampstead, NH 03841 (US)
(74) Representative: Liedl, Christine
(86) International application number: PCT/US2004/025800
(87) International publication number: WO 2005/045886

(56) References cited:
- EP-A1- 0 593 367
- US-A- 4 624 617
- US-A- 5 417 537
- US-A- 5 443 346
- US-A- 5 603 777
- US-A1- 2003 198 540
- US-B1- 6 468 021
- US-B2- 6 494 308
- US-B2- 6 851 913
- US-B2- 6 863 485
- US-B2- 6 990 721

## Description

### 1. Field of the Invention

The present invention relates to material handling systems and, more particularly, to a automated material handling systems for transporting semiconductor workpiece holding canisters or containers in processing facilities.

### 2. Earlier Related Developments

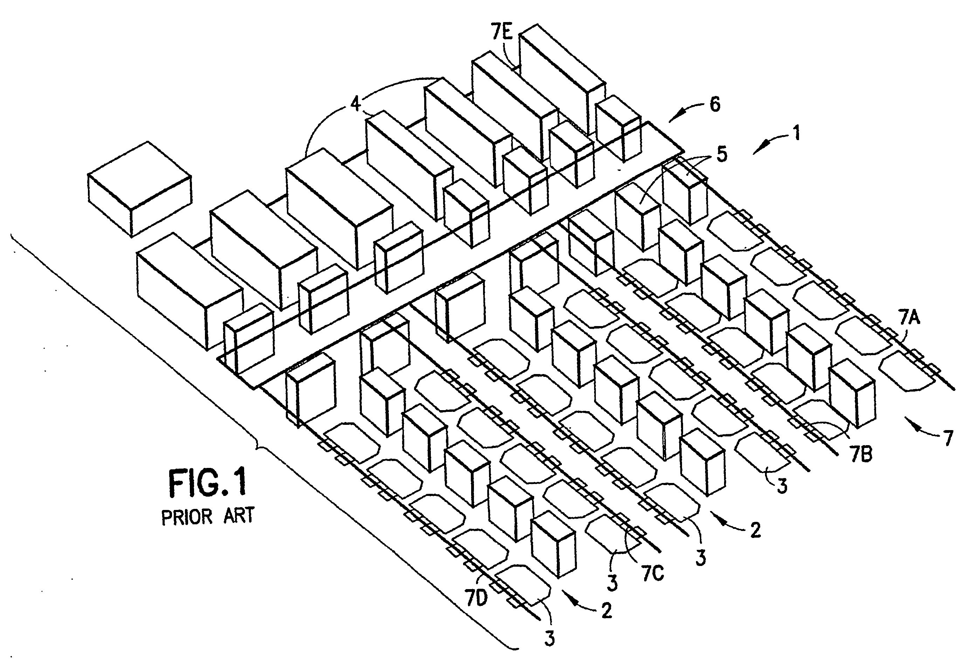

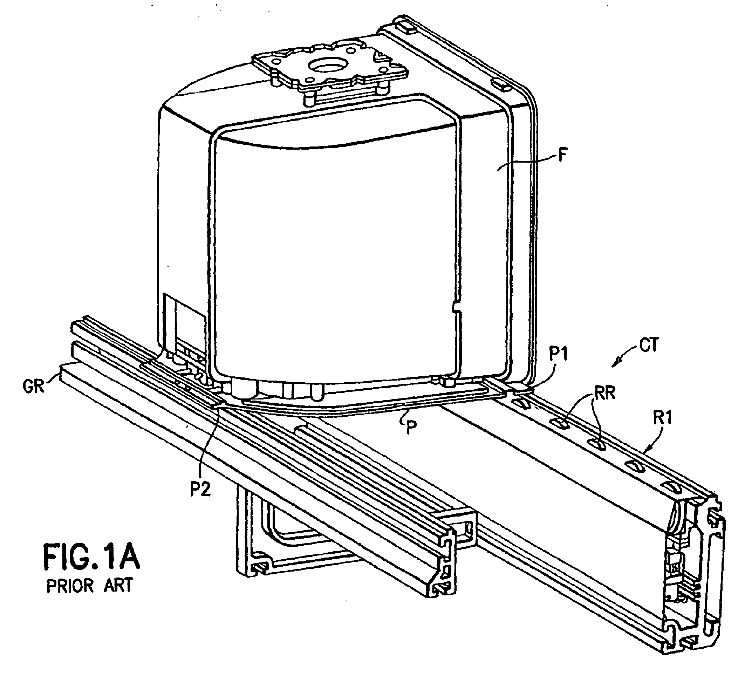

Consumers continue to manifest a desire for ever more sophisticated electronic and electrical devices that are smaller in size and cheaper than current models. Manufacturers of microelectronic devices are thus under increased pressure to provide more capabilities to the devices while at the same time reducing the cost of the devices. The potential for reduction in cost of the materials used in fabricating the microelectronic devices, or in the cost related to actual fabrication of the devices is limited. However, significant cost reductions may be achieved by increasing the efficiency of the whole manufacturing process. Referring to Fig. 1, there is shown a perspective view of a representative conventional semiconductor fabrication facility 1. The fabrication or fab facility 1 has a number of fab bays 2 arranged in the facility in a desired array. The fab bays 2 include vacuum and atmospheric processing tools 3, 4 where the semiconductor devices are manufactured. The fab facility 1 also has an automated material handling system installed therein for transporting the semiconductor material to and from the semiconductor devices. The conventional material handling system in the fab facility shown in Fig. 1, generally includes stockers 5, interbay transport system 6, and intrabay transport system 7. In this arrangement, the stockers 5, used to store the semiconductor devices between various processing evolutions, are located adjacent the opening of the fab bays 2 on a common passage linking the fab bays 2. The interbay transport system 6 is installed in the common passage and connects the stockers 5. This allows semiconductor devices to be transported, by suitable vehicles traveling on the interbay transport system 5 between stockers 5. The intrabay transport system 7, as seen in Fig. 1, has sections 7A-7B disposed in the fab bays linking the stockers 5 adjacent the opening of a given bay to the processing tools 3, 4 in that bay. Thus, semiconductor devices can be transported between the stockers 5 of a bay and the processing tools in that bay with suitable vehicles traveling on the corresponding section 7A-7F of the intrabay transport system.

As can be realized from Fig. 1, the automated material handling system is one of the significant factors in the efficient fabrication process in the fab facility. A significant amount of time is consumed transporting the semiconductor material with the material handling system, to and from the processing tools. Indeed, the larger the processing facility, in order to achieve economies of scale, the greater the time consumed transporting semiconductor material with the material handling system to and from processing tools within the facility. Thus, the size of the facility itself becomes limited by the speed and efficiency with which the material handling system is capable of delivering semiconductor material to the processing tools for processing, and removing the processed workpieces to stockers for ultimate completion and shipping. Attempts to increase efficiency by reducing transport time have been made, and have achieved success in cases. For example, the Aeroloader™ automated material handling system from Brooks Automation, Inc. employs overhead transport vehicles or shuttles on overhead tracks to transport semiconductor workpiece container over the interface of the processing tools. Further increases in speed, and hence efficiency, at which semiconductor workpieces are transported around the facility have been sought. Some conventional material handling systems, have used a conveyor or mass transport system alone or as part of the system. Fig. 1A is a partial perspective view of a portion of a conventional conveyor system such as for example disclosed in international patent publication WO 03/038,869, for transporting a conventional semiconductor workpiece container. The container F shown in Fig. 1A is conventional container such as a conventional FOUP or SMIF container. As noted before, Fig. 1A shows a portion of a conveyor track CT of the conventional system. The track CT in Fig. 1A may be representative of one or more of the tracks 7A-7F of the system in Fig. 1. The conventional conveyor track CT in Fig. 1A comprises a pair of rails R1, GR. The conventional conveyor system uses a pallet P as shown to support the conventional container F on the conveyor track CT. The pallet P has a support area on which the container F may be seated. The pallet P may also have runners P1, P2 to allow the pallet P to ride over the conveyor rails R1, GR. One runner P1 may be flat, defining a rolling surface for rollers RR in rail R1. The other runner P2, may have a guide slot, or guide key mated to the rail GR to guide the pallet P along the rails during transport. Rail R1 of the conventional conveyor track shown in Fig. 1A may include powered rollers RR to drive the pallet P on the rails. The rollers RR are coupled by a suitable transmission, such as an endless belt, to a drive motor capable of turning the rollers. To move the pallet P, and hence the container seated thereon, in the conventional system shown in Fig. 1A, the motor rotates the rollers RR and the frictional contact between rollers and pallet runner P1 causes the pallet to move. The other runner P2 of the pallet P, slidably mated to rail GR, guides the pallet as it is moved down the rails maintaining alignment between the pallet runner P1 and drive rollers RR. As can be realized from Fig. 1A, alignment between the pallet runner, and hence between rail GR, and the contact line of the line of rollers RR in rail R1 should be highly accurate in the conventional mechanical driven conveyor track to allow the pallet to be driven true to the track. The conventional system is not misalignment tolerant. Misalignment, may generate a force on the pallet orthogonal to the track, resulting in undesired friction, possible binding, between runner P2 and rail GR and in increased potential for particulate contamination on the container. In addition, alignment between rollers RR on rail R1 should be precise to avoid a contact/drive line between rollers and runner P1 that is angled relative to the track. Accordingly, precise alignment between the rails R1 and GR is achieved in the conventional system by fabricating extended sections of track CT in a jig prior to installation in the processing facility. However, such extended sections of track are difficult and time consuming to install in the processing facility. An additional shortfall of the conventional conveyor system is its poor ability to position a container at a desired location along the track. The conventional conveyor system may include a position locating system for the pallet. The conventional locating system includes providing one of the rails R1 with sensors (e.g. electronic, electro-optical) capable of detecting a feature on the pallet P when the pallet is in a predetermined area relative to the sensors. The sensors are equally distributed along the rails. The rollers RR, alone or in combination with the drive motors may have an encoder identifying the rotation of the rollers. The position of the pallet P at any time is established using the combination of data from the rail sensors and rollers. As can be realized, the conventional locating system is subject to inaccuracies because of possible slippage between rollers RR and pallet during acceleration/deceleration, as well as that locating the pallet between sensors is dependent merely on counting roller revolutions. The combination of the limitations of frictional drive and the conventional position location system deprive the conventional conveyor track of effective fine position control. A further problem of the convention conveyor system is that movement of semiconductor material containers on the transport system is dependent on availability of transport pallets. The present invention provides the desired efficiency for the material handling system, as will be described in greater detail below.

In this connection, US patent 6,468,021 B1 and US patent 5,443,346 already show semiconductor work piece processing systems comprising at least one processing tool for processing semiconductor work pieces; a container for holding at least one semiconductor work piece therein for transport to and from the processing tool; a first transport section connecting to the processing tool for transporting the container to and from the processing tool; and a second transport section connected to the first transport section for transporting the container to and from the first transport section; wherein the first transport section is a vehicle based section having a transport vehicle capable of holding the container and moving along a first track of the first transport section, and the second transport section is a conveyor section and has a second track with at last one support element of the second track adapted to interface with the container for movably supporting the container from the second track and allowing the container to move relative to the first track, and wherein the second transport section has a motor connected to the second track for aligning the container on the second track with the transport vehicle on the first track.

The system of US 6,468,021 B1, however, only uses the first transport section to transport the containers arriving on the conveyor based transport for small distances vertically. In this citation, all horizontal transporting jobs are made by the conveyor system. The vehicle based system only serves to transport the containers vertically to their final destination at a processing station.

In US 5,443,346, the vehicle based system is also arranged orthogonally to the conveyor based system and also only serves to transport the containers arriving on the conveyor system for "the last meter" to the processing stations.

According to the invention, this object is achieved by the features of claim 1. The subclaims contain preferred features for further developing this system.

### BRIEF DESCRIPTION OF THE DRAWINGS

The foregoing aspects and other features of the present invention are explained in the following description, taken in connection with the accompanying drawings, wherein:
Fig. 1 is a schematic perspective view of a semiconductor fabrication facility with a conventional material handling system;
Fig. 1A is a partial respective view of a portion of the conventional handling system in Fig. 1;
Fig. 2 is a schematic plan view of an automated material handling system incorporating features of the present invention and processing tools P in a processing facility;
Fig. 3 is a partial perspective view of a portion of the automated material handling system in Fig. 1, showing track sections, a transport vehicle and semiconductor workpiece containers of the automated material handling system;
Fig. 4 is another partial perspective view of a portion of one of the track sections in Fig. 3 and a transport vehicle of the automated material handling system;
Fig. 5 is still another partial perspective view of a portion of another one of the track sections in Fig. 3 and a semiconductor workpiece container of the automated material handling system;
Figs. 6A-6B are respectively front and side elevation views of the track sections in Fig. 3, a transport vehicle and semiconductor workpiece container of the automated material handling system;
Fig. 7 is an exploded perspective view of the workpiece container and Fig. 7A is a bottom view of the workpiece container; and
Figs. 7B-7C respectively are bottom perspective views of a lower part of the workpiece container housing in accordance with other embodiments.

### DETAILED DESCRIPTION OF THE EMBODIMENT

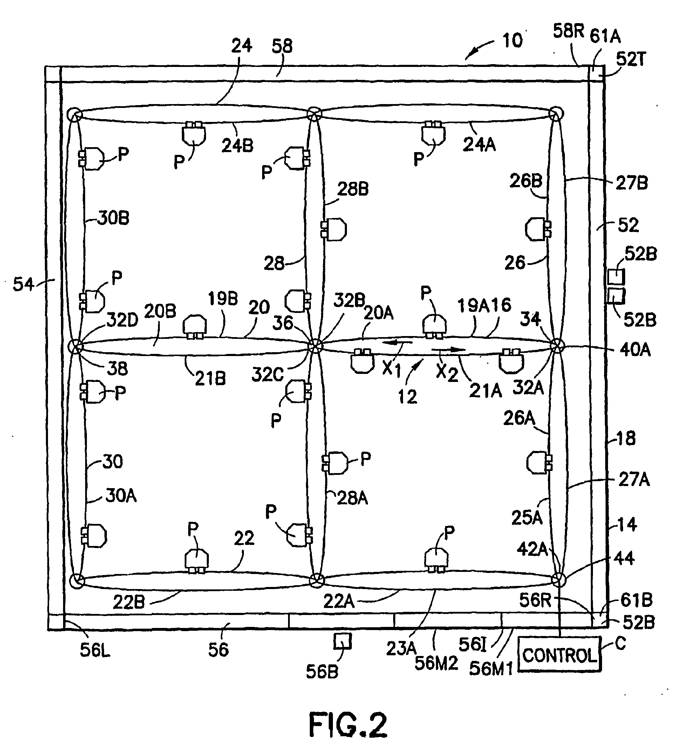

Referring to Fig. 2, there is shown a schematic plan view of an automated material handling system 10 incorporating features of the present invention and processing tools P in a processing facility. Although the present invention will be described with reference to the single embodiment shown in the drawings, it should be understood that the present invention can be embodied in many alternate forms of embodiments. In addition, any suitable size, shape or type of elements or materials could be used.

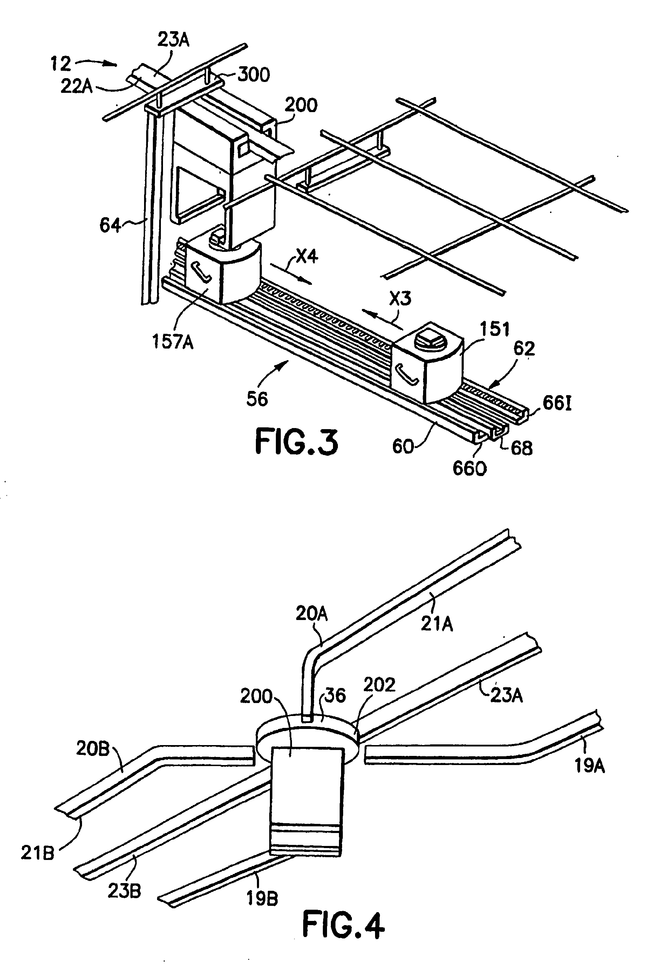

The automated material handling system 10 generally includes a first transport system section 12 and a second transport system section 14. The transport system sections 12, 14 of the automated material handling system 10 are generally arranged to allow transportation of semiconductor workpieces, such as for example, 200 mm wafers, 300 mm wafers, flat display panels and similar such items, to and from processing tools P in the processing facility. The processing tools P, and the facility are generally similar to the facility 1 and tools 4 described before and shown in Fig. 1. The configuration of the automated material handling system 10 shown in Fig. 2 is a representative configuration, and the automated material handling system 10 may be disposed in any suitable configuration to accommodate any desired layout of process tools in a processing facility. One transport system section 12 of the automated material handling system 10 is a vehicle based system. The transport system section 12 comprises tracks 16 and transport vehicles 200 (see also Fig. 4). The transport vehicles 200, as will be described in greater detail below, are capable of holding a semiconductor workpiece container (not shown in Fig. 1) and travel along the tracks 16 of transport section 12. The transport vehicles 200 thus move the workpiece containers along tracks 16 between processing tools, or between processing tools and stockers (not shown) similar to stockers 5 shown in Fig. 1. The other transport system section 14 of the automated material handling system 10 is not a vehicle based transport system. Transport system section 14 is a conveyor based or high speed (relative to a vehicle based system) mass delivery system. Transport system section 14 comprises a track or run 18 capable of directly conveying, without the use of intermediate transport vehicles, semiconductor workpiece containers at high speed as will also be described in greater detail below. The track 18, as shown schematically in Fig. 2, may extend along at least some portions of track 16 of the other transport system section 12. The track 18 of transport system section 14 may also span between different portions of track 16 of transport system section 12. The semiconductor workpiece containers may be transferred as desired between the track 18 of section 14 and transport vehicles 200 (see Fig. 3) on track 16 of section 12. The automated material handling system 10 may transport semiconductor workpiece containers using any desired combination of the first and second transport system sections 12, 14 in order to achieve the most efficient delivery and return of semiconductor workpiece containers from the processing tools. As seen in Fig. 2, a suitable controller C is connected to the first and second transport system sections 12, 14 to control operation of the sections. The second transport system section 14 may also provide a distributed storage or buffer for the automated material handling system as will be described in greater detail below.

In greater detail now, and with reference to Figs. 3 and 4, the first system section 12 of the automated material handling system 10 generally includes track 16 and transport vehicles 200, as noted above. System section 12 may be generally similar to the automated material handling system described in US-A-2004181929. As seen in Fig. 2, the track 16 of system section 12 may be arranged into interbay 20, 22, 24 and intrabay 26, 28, 30 portions or branches. The intrabay branches 26, 28, 30 of the track may extend within individual fabrication bays (similar to the bays shown in Fig. 1) of the fab facility. The interbay branches 20, 22, 24 may extend within corridors or passages connecting the fabrication bays, and interconnect two or more intrabay branches 26, 28, 30 to each other. In the embodiment shown in Fig. 2, there are three intrabay branches 26, 28, 30 and three interbay portions 20, 22, 24. Each of the three interbay branches 20, 22, 24 extends to connect all three intrabay branches 26, 28, 30. In alternate embodiment, the first system section of the automated material handling system may have any suitable number of interbay and intrabay transport portions.

The interbay transport branches 20, 22, 24 of the embodiment shown in Fig. 3 are substantially parallel to each other, though in alternate embodiments different interbay branches may not be parallel. Indeed, interbay transport branches may not connect all fab bays and may have any shape. The present invention encompasses any interbay transport system arranged in any desired manner to connect any desired number of fab bays. In this embodiment, the interbay transport branches 20, 22, 24 are generally similar to each other, and will be described below with specific reference to the central portions 20. The interbay transport branch 20 may be made up of interbay transport segments or elements 20A-20B. In the embodiment shown in Fig. 2, there are two segments 20A-20B for example purposes only, and in alternate embodiments the interbay transport branch may have any desired number of segments. Each segment 20A-20B is of sufficient length to span between two adjoining fab bays and specifically between adjacent portions of the intrabay transport system. For example, segment 20A spans between adjoining intrabay port ions 26, 28. In alternate embodiments, the span of each segment may be different.

As seen in Fig. 2, each segment 20A-20B may have multiple transport paths 19A-21A, 19B-21B, 19C-21C provided by any suitable table means (as will be described below) for transport vehicles (not shown), allowing the vehicles to traverse the segment. The transport paths of each segment are arranged to allow substantially simultaneous bi-directional travel of the transport vehicles on the segment (in directions indicated by arrows X1, X2). In this embodiment, each segment 20A-20B may have two transport paths 19A-21A, 19B-21B extending between the ends of the segment. One path, such as for example 19A, 19B, may be used by transport vehicles to travel in one direction (indicated by arrow X₁) and the other path, 21A-21B, may be used for travel in the opposite direction (indicated by arrow X₂). The travel paths may be dedicated to a given direction of travel or the direction of travel may be switched as desired according to a transport algorithm to suit transport loading conditions. For example, in the non-dedicated case, transport path 19A of segment 20A may at first be used for vehicles traveling in the direction indicated by arrow X₁ in Fig. 2. At that time, path 21A provides for travel in direction X₂. However, if at some later time it is anticipated that some number of transport vehicles are situated in the facility and are going to a location where it would be more efficient to move over path 19A in direction X₂, then the travel direction for path 19A may be changed to direction X₂, path 21A then becoming used for X₁ travel. It is noted, that in this embodiment travel direction need not be the same for similar paths 19A-19B, 21A-21C of each segment. For example, transport path 21A may be used for travel direction X₂, but transport path 21B may be used for the opposite travel direction X₁. This ability is provided by the interbay transport segments 22A-22C in this embodiment because as seen in Fig. 2, the corresponding transport paths of each segment converge towards each other at opposite ends 32A-32B and 32C-32D of each segment 20A-20B. As seen in Fig. 2, each segment 20A-20B has a junction 34, 36, 38 at corresponding opposite ends of the segment. For example, in the embodiment shown in Fig. 2 segment 20A has a junction 34 at one end 32A and another junction 36 at the opposite end 32B. The respective travel paths 19A-19B, 21A-21B of each segment 20A-20B substantially intersect at each corresponding junction 34, 36, 38. As seen in Fig. 2, the junctions 36 between segments are used to connect the adjoining segments to each other. Junction 36 connects adjoining ends 32B-32C of segments 20A, 20B. Junction 36 may further allow ties between same or different transport paths of the connected segments. For example, junction 36 may be used to tie transport path 19A of segment 20A to the transport path 21B of segment 20B thereby allowing transport vehicles to cross between paths 21B and 19A of the adjoining segments. In alternate embodiments any other suitable configuration of segments and junctions interconnecting segments may be used.

In this embodiment, the intrabay branches 26, 28, 30 are substantially similar to the interbay branches 20, 22, 24. Still referring to Fig. 2 as noted before, the intrabay transport is also made up of three branches for example purposes. Each branch may comprise a single transport segment or element, or may comprise a number of interlinked segments. In the embodiment shown in Fig. 2, each branch has two segments 26A-26B, 28A-28B, 30A-30B. Each branch segment 26A-30B may extend within a single fab bay or may be further branched to other fab bays. The intrabay transport segments 26A-26B, 28A-28B and 30A-30B are generally similar to each other and hence are schematically illustrated the same in Fig. 2. Each of the segments 26A-26B, 28A-28B, 30A-30B has multiple transport paths, similar to the interbay segments 20A, 20B described before, allowing substantially simultaneous bidirectional travel of transport vehicles along each segment. The transport paths of each segment, for example, paths 25A, 27A of segment 26A, may converge towards each other at opposite ends 40A, 42A of the segment. At the near end 40A the transport paths terminate in junction 34. As noted before, junction 34 is the terminus of interbay transport paths 19A, 21A of an interbay transport segment 20A. Thus, the interbay transport paths 19A, 21A may be unified with the intrabay transport paths 25A, 27A of the intrabay transport segment 26A. In this embodiment, the transport paths, such as for example, paths 26A, 27A of segment 26A, terminate in a junction 44 at the far end 42A. Junction' 44 ties in the transport paths to interbay transport segment 22A. In a similar manner, junctions may tie the transport paths of intrabay segments 26B-30B to the outer interbay transport segments 24A-24B. In alternate embodiments, the intrabay transport segments may have any other suitable arrangement.

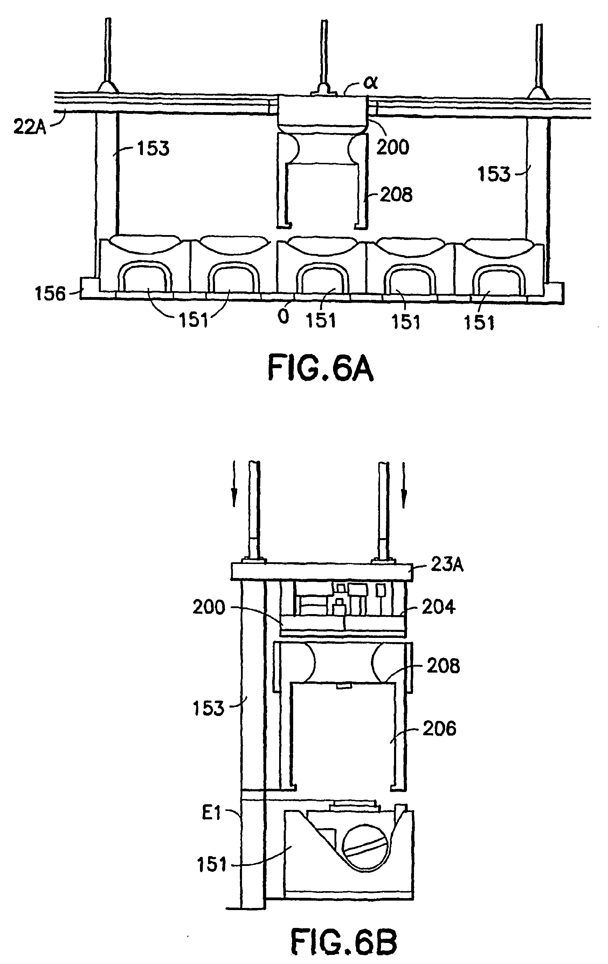

The interbay and intrabay branches of first transport system 12 are shown in Fig. 2 and have been described above in the context of a representative configuration that can be provided by any number of suitable types of material handling systems. Fig. 4 is a partial perspective view of a representative portion of an interbay or intrabay transport branch showing one suitable example of the types of handling system materials that may be used for the automated material handling system 10. As seen in Fig. 4, the interbay transport segments 20A-20B (only parts of segments 20A, 20B are shown in Fig. 4 for example purposes) are formed using an overhead rail system such as the Aeroloader™ system available from Brooks Automation, Inc. In this case, each transport path 19A-19B, 21A-21B is provided by a corresponding rail or track. The tracks may be mounted to the fab facility overhead. Referring also to Figs. 6A-6B, there are shown respectively partial front and side elevation views of tracks 20A and a transport vehicle 200.

Fig. 4 shows a third track 23A, 23B for each segment (not shown in Fig. 2 for clarity) which provides a high speed or "fly-through" transport path for each segment. As described before, the tracks converge at the junction 36 between the adjoining segments. In the embodiment shown in Fig. 4 junction 32 includes a turntable 202, though any suitable track switching device may be used. In this case the turntable has three positions to tie the diametrically opposed track ends of the respective transport paths 21A-19B, 23A-23B, 19A-21B. When the turntable is positioned in one of these positions, a transport vehicle 200 may cross between diametrically opposed track ends without moving the turntable. Otherwise, the transport vehicle may be positioned onto the turntable, and the turntable may be rotated as desired to allow the transport vehicle to move from any track 19A, 23A, 21A of one segment to any other track 19B, 23B, 21B of the connected segment. The movement of the turntable may be automated, controlled by a suitable program from the central processor of the system.

Automated overhead transport vehicles 200 (only one is shown in Figs. 4 and 6A-6B for example) such as the Aeroloader™ system shuttles are mounted on one of the tracks. The transport vehicle 200 may be sell propelled to autonomously travel on the corresponding rail forming each of the travel paths. Each vehicle travels on the desired transport paths according to a transport algorithm which may be preprogrammed into vehicle memory (not shown) or loaded from a central processor (not shown) operating the automated material handling system. In this embodiment, though any other suitable type of transport vehicle may be used. The transport vehicle 200 may have a transport section 204 (see Figs. 6A-6B) and a payload section 206. The transport section 240 includes suitable wheels/rollers (not shown) to support and move the vehicle on the track. The transport section may also include a power source and motor for driving the vehicle along the track. The payload section 206 is mounted or otherwise supported from the transport section, and in this embodiment is suspended below the transport section (see Figs. 6A-6B). The payload section 206 may include a hoist 208, in this embodiment schematically depicted as having gripper arms, capable of capturing and raising/lowering a workpiece holding container 151. Figs. 6A-6B show a representative workpiece storage container 151 that may be used with the handling system 10 (and which will be described in greater detail below) located in a position where the hoist 208 of the transport vehicle is capable of engaging the container 151. The storage container 151 may be in a storage area (not shown), such as a uniformly distributed storage area, under a track of any desired interbay or intrabay transport segment (representative segment 22A is shown for example purposes), or may be on the interface of a processing tool P (see Fig. 2) located below the track. As seen in Fig. 2, the tracks of the interbay and intrabay branches may be located over the tool interface of the processing tools P. Accordingly, transport vehicle 200 is capable of delivering and picking up workpiece container directly from the processing tools P.

Referring again to Fig. 2, the transport system section 14, as noted before, is a conveyor based system, and unlike transport system section 12, does not use transport vehicles for holding and transporting the workpiece holding containers. Rather, transport system section 14 has a conveyor or mass delivery system arranged in conveyor runs, as will be described in greater detail below, that effect direct transport of the workpiece holding containers along the conveyor runs. As will also be described in greater detail below, the workpiece holding containers may be placed directly onto the conveyor runs, and are transported along the runs without using a transport vehicle or carriage interface between the holding container and run. As seen in Fig. 2, in this embodiment the transport system section 14 has four runs 52-58. In this embodiment, the conveyor runs 52-58 are located around the perimeter of the transport system section 12. In alternate embodiments, the conveyor runs may be arranged in any suitable configuration. In this embodiment, two conveyor runs 52, 54 extend alongside intrabay transport branches 26, 30, and two conveyor runs 56, 58 extend alongside interbay transport branches 22, 24. Conveyor runs 52, 54 span between interbay branches 22, 24, and conveyor runs 56, 58 span between intrabay branches 26, 30. As seen in Fig. 2, each conveyor run 52-58 is proximate to a track of a interbay or intrabay transport branch. In this embodiment, each conveyor run 52-58 is substantially parallel with a corresponding interbay or intrabay transport branch 22, 24, 26, 30. Hence, for example, conveyor run 52 is proximate track 27A, 27B of intrabay branch 26 for substantially the length of branch 26. Conveyor runs 54-58 are similarly positioned relative to corresponding transport branches. Although the conveyor branches 52-58 are shown in Fig. 2 positioned proximate the outermost track of the respective interbay/intrabay branches, in alternate embodiments the conveyor runs may be proximate any suitable track of any desired interbay/intrabay transport branches. In other alternate embodiments, the conveyor runs may extend along any desired length of a interbay/intrabay transport branch. In still other alternate embodiments, the transport system section may have conveyor runs that are not located alongside an interbay/intrabay transport branch, such as for example conveyor runs effecting short circuits within the transport system section. As seen in Fig. 2, the conveyor runs 52-58, may each be interconnected at the ends to intersecting conveyor runs by a suitable junction device allowing a workpiece holding container to transit directly between runs. For example, one end 52T of conveyor run 52 is connected by junction 61A to end 58R of conveyor run 58. The other end 52B of conveyor run 52 is connected by junction 61B to end 56R of conveyor run 56. The other conveyor runs of transport system section 14 may be similarly interconnected. As can be seen from Fig. 2, the conveyor runs 52-58 of section 14 form a circuit enabling high speed transport of workpiece holding containers from any point of the adjoining transport system section 12 to any other desired point of section 12. This is highly advantageous compared to conventional transport systems.

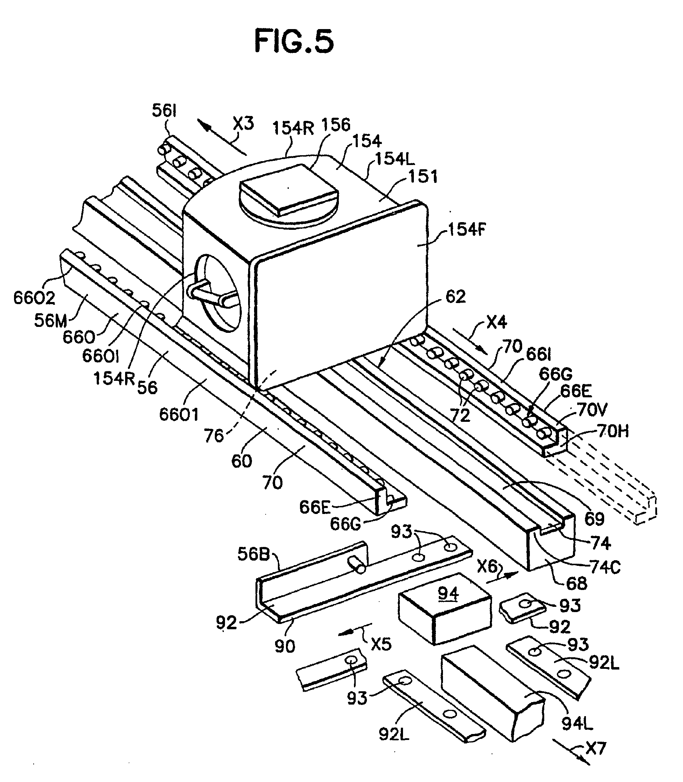

The transport system section 14 of automated material handling system 10, is shown in Fig. 2, and described above in the context of a representative configuration that can be provided by any number of suitable types of conveyor systems. Referring now also to Figs. 3 and 5, there is shown respectively a partial perspective view of a portion of transport branch 22A of the transport system section 12 and a portion of a conveyor run 56 of the transport system section 14, and another partial perspective view of a portion of conveyor run 56. The portions of transport branch 22A and conveyor run 56 are representative of the transport branches and conveyor runs of transport system sections 12, 14. In Fig. 3, only one track 23A (see also Fig. 2) of the branch segment 22A is shown for example purposes. As seen in Fig. 3, the conveyor run 56 is mounted with mounting system 64 (which will be described in greater detail below) to the overhead mounts 300 of the track 23A making up the interbay branch segment 22A. Conveyor runs 52, 54, and 58 are mounted in a similar manner from the overhead mounts of adjacent interbay/ intrabay transport branches. Conveyor run 56 generally comprises a rail system 60. The rail system 60 supports workpiece holding containers 151 and allows the containers to move freely along the length of the run 56. Conveyor run 56 also has a motor 62 for driving the containers 151 on rail system 60 back and forth (in the direction indicated by arrows X3, X4 in Fig. 3) along the rails. In this embodiment, the motor 62 is a linear motor with an unlimited stroke. As seen best in Fig. 5, the rail system 60 in this embodiment has two outer runs 660, 66I and a central rail. In alternate embodiments, the rail system of the conveyor runs may have any other suitable rail arrangement. The outer rails 660, 66I are similar but opposite hand. Accordingly, the outer rails 660, 66I will be described with specific reference to rail 66I. Rail 66I may have a general angle structural member 70, though any suitable structural shape member may be used. The angle 70 has horizontal and vertical flanges 70H, 70V. The angle 70 is oriented with the horizontal flange 70H on the bottom and the vertical flange 70V extending upwards. The horizontal flange 70H may define a support surface for the workpiece holding containers 151 placed on the conveyor run. The vertical flange 70V defines the outer edge 61E of the rail 66, and hence of the rail system. The vertical flange may also define a guide surface 66G of rail 66 containing the side of the container 151 for directional stability when the container 151 is moving along the rails 660, 66I in the directions indicated by arrows X3, X4 in Fig. 5. Accordingly, the opposing guide surface 66G stably guide the container 151 when it moves on the rails 660, 66I. As seen in Fig. 5, each rail 660, 66I may be provided with roller bearings or bushings 72 that are mounted to the rail to provide the rail with an enhanced sliding surface on which the container may slide over the rails. By way of example, when seated on the conveyor run 56, the container 151 rests on roller bearings 72 and may thus move without substantial resistance over the rollers. In alternate embodiment, the enhanced sliding surface of the rails may be provided by any other suitable means including for example ball bearings (mounted in one or both flanges) or a lubricious layer attached to the flanges of the rail member. Roller bearings 72 may be tapered for added directional stability when the container 151 is moving over the rollers in directions indicated by arrows X3, X4.

Center rail 68 of rail system 60 forms part of the linear motor 62 of the conveyor run 56. As noted before, linear motor 62 may be any suitable type of linear motor with an unlimited stroke capable of moving containers 151 on rails 660, 66I in directions X3, X4 to the ends of the conveyor run (see Fig. 2). The linear motor 62 is in general a solid state motor without moving parts. For example, the linear motor 62 may be a brushed or brushless AC or DC linear motor, a linear induction motor, or linear stepper motor. Suitable linear motors are available from Baldor Motion Products or MagneMotion Inc. The linear motor 62 generally has two components, a primary or forcer component and a secondary, reaction or platen component. In this embodiment, the forcer component 74 is in the center rail 68 of the conveyor run 56, and the reaction component 76 is integrated, as will be described in greater detail below, into the workpiece holding container 151. In alternate embodiments, the reaction component may be mounted to the conveyor rails and the forcer component may be incorporated into the container. By way of example, if a linear induction motor is used for linear motor 62 in the embodiment shown in Figs. 3 and 5, the center rail 68 may have a generally U-shaped structural member defining a groove 69. The forcer component 74 of the motor 62 is located in the groove. In the case of a linear induction motor, forcer 74 may be a coil assembly comprised of steel laminations and phase windings. The forcer 74 is connected by suitable wiring (not shown) to a power source (not shown) and controller C (see Fig. 2) that controls the traveling magnetic field generated by the forcer 74. The motor 62 may be a closed loop motor with suitable commutation devices 74C, such as Hall effect devices mounted for example on rail 68 and in communication with controller C. As will be described further below, the commutation devices 74C serve as a position sensor, sensing the exact position of the container 151 on the conveyor run 56.

As seen in Fig. 5, the rails 66I, 660, 68 of the rail system 60 may have a modular construction. For example, rail 660 may include modules 6601, 6602 (only rail modules 6601, 6602 are shown in Fig. 5 for example purposes). The rail modules 6601, 6602 are joined at the intermediate joint 660I. The rail modules 6601, 6602 are provided with any suitable mating means, (e.g. interlocking facets, mechanical, fasteners) allowing the modules to be joined together end to end as shown in Fig. 5. The center rail 68, and outer rail 66I have a similar modular construction. The rail modules similar to modules 6601, 6602 may be provided in any suitable length, such as a few feet, for ease of handling during installation. The rail modules may be joined together during installation to form the rails 660, 66I, 68 of the rail system of the conveyor run 56. By way of example, rail modules similar to modules 6601, 6602 may be assembled during installation in the facility to form rail 66 from one end 56L (see Fig. 2) of run 56 to the other end 56R. The center rail 68, and other outer rail 66I may be similarly installed to form conveyor run 56. The rail modules, such as modules 6601, 6602, may otherwise be installed to modularly install the conveyor run 56. For example, modules for all rails 66I, 660, 68 may be installed to form one or more conveyor run modules 56M1, 56M2 (see Fig. 2). The conveyor run 56 installation then proceeds module by module. Modules 56M1, 56M2 of conveyor run 56 are described above as being installed first for example purposes only, and in alternate embodiments the center modules of the conveyor run may be installed first. The conveyor modules 56M1, 56M2 are joined at intermediate run joints 56I. Once installed, each conveyor run module 56M1, 56M2 may become operational as soon as desired and before completion of the entire run 56. This is allowed in part by the use of the solid state motor 62 which unlike conventional conveyor systems does not employ a mechanical transmission that is coupled to all the drive rollers before the conveyor run may become operational. Further, unlike conventional systems, motor 62 is capable of precisely starting and stopping the container transported by the conveyor run 56 as will be seen further below. Yet another advantage arising from transport system section 14 using a solid state motor, similar to linear motor 62, is that the solid state motor by its very nature can readily accommodate, without noticeable performance degradation, misalignment between rail modules. The linear motor 62 of section 14 is capable of operating with misalignment between modules of the center rail 68 commensurate with modular structural assembly tolerances under field conditions. In marked contrast, a conventional mechanical conveyor drive system (such as illustrated in Fig. 1A) is restricted to the much tighter mechanical tolerances of the drive. Consequently, the drive rails for a conventional conveyor run must be fabricated in one piece offsite for substantially the entire length of the run, and then installed as one piece in the facility. Hence, the transport system section 14 has much greater flexibility in both installation and use during start up compared to conventional systems.

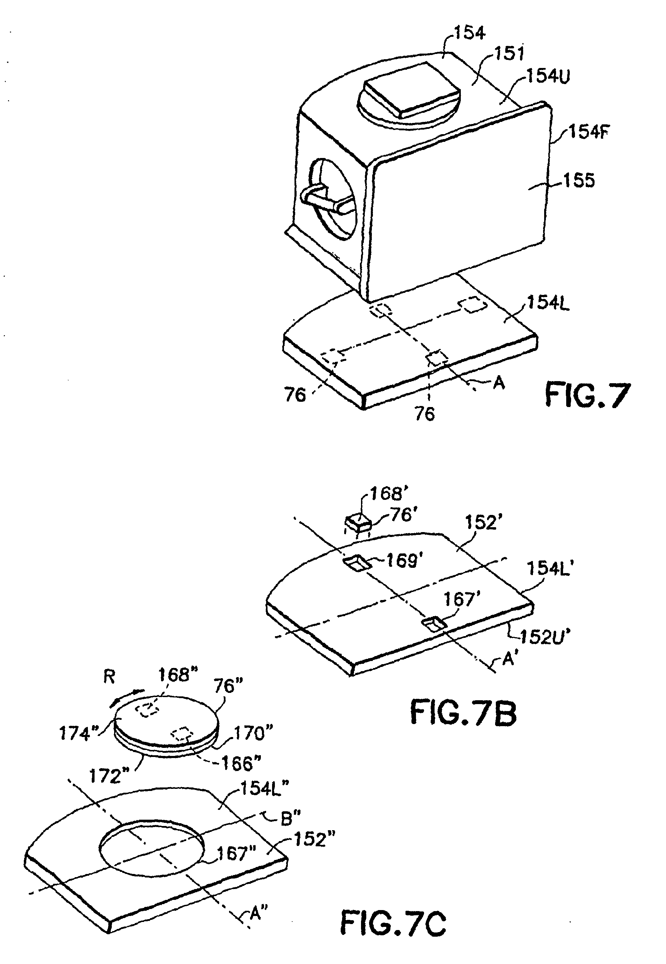

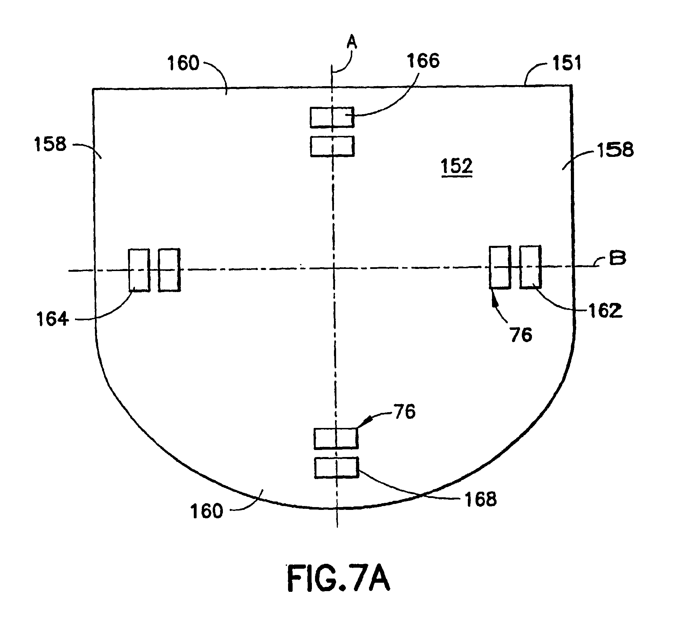

As noted above, the reaction component of platen 76 of the linear motor is incorporated into the workpiece holding container 151. Referring now also to Fig. 7, which shows a bottom view of the container 151, the workpiece holding container 151 is depicted as a Front Opening Unified Pod. (FOUP) container, but can be any suitable container such as a SMIF pod or a bottom opening container. The FOUP container 151 has a container housing 154 (see Fig. 5) sized to hold a number of semiconductor workpieces such as 200 mm, 300 mm wafers, or flat panel displays or any other desired kind of workpieces. The housing 154 is capable of interfacing directly with the interface of processing tools P (see Fig. 2). The housing 154 may include engagement surfaces 156, such as detents or recesses to allow the hoist 206 (see Figs. 6A-6B) of the transport vehicle 200 to capture and hold the container 151. For example, the engagement surface 156 may be arranged to allow the capture arms 208 of the hoist 206 to pick the container from either sides 154R, 154F or front/back sides 154R, 154L (see Fig. 5). Hence, the hoist 206 of vehicle 200 may pick the container 151 regardless of the orientation of the container under the hoist.

Referring now to Fig. 7, there is shown an exploded perspective view of the container 151. As seen in Fig. 7, the container housing 154 may include an upper part 154U and a lower part 154L. Container door 155, which is removably latched to the housing, is shown covering the opening in the front 154F of the housing. The upper part 154U of the housing may be a one-piece molding made from plastic or any other suitable material capable of being used to hold semiconductor workpieces without contamination. The material for the housing is capable of being subjected to a full immersion bath during periodic cleaning of the container The lower part 154L of the housing is also a plastic molding. In the embodiment shown in Fig. 7, the lower housing part 154L has a general flat shape forming the bottom of the container. The lower part 154L may be joined to the upper part 154U using any suitable process, such as chemical bonding, ultrasonic welding or others resulting in a substantially seamless interface between the lower and upper housing parts. In the embodiment shown in Fig. 7, the reaction component 76 of the linear motor 62 (disclosed in greater detail below) is molded within the lower part 154L.

The lower housing part 154L has a lower surface 152, shown in Fig. 7A. The lower surface 152 has seating surfaces 158, 160 disposed in a biaxial arrangement on the lower surface. In this embodiment, the seating surfaces 158, 160 are located around the perimeter of the lower surface 152, to allow the container to seat against the rollers 72 of rails 660 66I (see Fig. 6). The biaxial arrangement of the seating surfaces allows the container to be properly seated on the rails with either axis A, B oriented with the rails. Fig. 7A also shows an exemplary distribution of the reaction component 76 of linear motor 62 in this embodiment. As noted above, the reaction component 76 is molded in the lower container housing molding 154L. Hence, the reaction component 76 is sealed within the lower housing part 154L. This eliminates seams between the reaction component and surrounding housing structure thereby eliminating areas where contaminants may collect. Further, by enclosing the reaction component 76 within the housing adverse interaction between the reaction component and cleaning bath is avoided. The reaction component 76, comprises, in this embodiment, reaction elements 162, 164, 166, 168 which are schematically illustrated in Fig. 7A. The reaction elements 162, 164, 166, 168 are also arranged biaxially on the container housing 154. The reaction elements may be permanent magnets or plates made from magnetic material capable of reacting with the magnetic fields generated by the forcer 74 to drive or thrust the containers along the rails 660, 66I. Reaction elements 162, 164 (two elements, each possibly being made up of sub-elements, are shown on opposite sides of the lower surface for example purposes, and in alternate embodiments the reaction elements may be provided in any suitable number and any suitable arrangement) are aligned along axis B in order to provide drive forces (in cooperation with forcer 74 or other forcers aligned with axis B) in the axis B direction. Reaction elements 166, 168 are arranged to provide drive forces in a similar manner along the A axis. The container 151 is shown in Fig. 5 placed on the rails 660, 66I in an orientation where axis A (see also Fig. 7) is aligned with forcer 74. As can be realized, the container 151 may be placed on the rails in an orientation rotated 90° from that shown in Fig. 5. In that case, the container 151 axis B would be aligned with the forcer 74. The biaxial drive configuration effectively reduces the time used to place or pick the container from the conveyor run 56 in comparison to conventional transport systems (i.e. smaller rotation to find usable drive axis compared to conventional systems).

Fig. 7B is a bottom perspective view of the lower housing part 154L' in accordance with another embodiment. The lower housing part 154L' in this embodiment is generally similar to lower housing part 154L described before and shown in Figs. 7-7A, and similar features are similarly numbered. Lower housing part 154L' has recesses 167', 169' formed therein for mounting the reaction component 76' to the container housing. In the embodiment shown in Fig. 7B, two recesses, 167', 169' are shown for example purposes, generally aligned with axis of symmetry A'. The recess 1167', 169' are formed in the bottom surface 152'. This leaves the bottom surface of the reaction component elements exposed when installed. In alternate embodiments, the recesses may be formed into the upper surface 152U' of the lower housing part so that when installed the reaction component elements are not exposed on the outer surface of the housing. The recesses, 169', 167' are blind as shown and do not extend through the lower housing part, though in alternate embodiments, apertures through the lower part may be used in place of the recesses. The recesses 169', 167' may be formed during molding of the lower housing part 154L' or may be machined into the lower housing part after fabrication of the housing part. The recesses 169', 167' are substantially conformal to the reaction component elements (only reaction component element 168'is shown for example purposes) and are sufficiently deep so that when positioned into the corresponding recesses, the bottom surface of the reaction component elements is substantially flush or somewhat inwardly displaced from the bottom surface 152' of the housing. The reaction component elements 168' may be mounted to the lower housing part using any suitable bonding or fastening means including mechanical fasteners. Suitable seals (not shown) may be used to eliminate gaps/crevices that may collect contaminants. In other alternate embodiments, the bottom of the housing may not include recesses or pockets, and the reaction component elements may be surface mounted to the bottom. In still other alternate embodiments, the reaction component elements may be assembled in a frame, and the frame may be mounted to the bottom of the container housing, or positioned into a recess in the housing. In this case, the reaction component may be replaceable.

Referring now also to Fig. 7C, there is shown another bottom perspective view of the lower part 154L" of the container housing in accordance with yet another embodiment. Except as otherwise noted, the lower housing part 154L" is generally similar to the housing part 154L described before and shown in Fig. 7. Similar features are similarly numbered. In this embodiment, the reaction component 76" is mounted in a turn table assembly 170". The turn table assembly 170" may be mechanically mounted or otherwise connected to the bottom 152" of the housing lower part. The assembly 170" may be surface mounted or may be located in a recess 167" as shown in Fig. 7C. If desired, the turn table assembly 170" may be replaceable. The turntable 170" may have any suitable configuration, but in general it includes a base 172" and pivot section 174". The base 172" provides the interface for attaching the turn table 170" to the housing part 154L". The pivot section 174" is movably mounted to the base section 172" by any suitable means to allow the pivot section 174" to rotate relative to the base section in the direction indicated by arrow R. The react ion component 76", schematically shown in Fig. 7C having representative elements 166", 168" is attached to the pivot section 174". Hence, by pivoting section 174", the orientation of the reaction component 76" may be changed as desired. For instance, rotating the turntable may move elements initially oriented along axis A" to any desired orientation such as alignment with axis B". The turntable may be provided with appropriate interlocks (not shown) to fix the turntable in any orientation. The interlocks may be activated with the forcer 74 of the linear motor. The forcer of the linear motor may also be used in cooperation with reaction component 76" to effect rotation of the turntable.

When the container 151 is placed on the conveyor run 56, the controller C (see Fig. 2) controls the traveling magnetic field generated by forcer 74 to move the container as desired. The controller C registers the position of the container 151 during movement on the conveyor run 56 via for example, the commutation sensors 74C. In the case where the linear motor is a brushed motor, the controller may register the location of the container by detecting the direct commutation in the motor. The controller C may move container 151 along the conveyor run 56, in either direction indicated by arrows X3, X4 in Fig. 3 at any desired speed and to any desired position. The controller C is capable of accurately placing the container 151 at any desired position along the run 56. This is possible for all the conveyor runs 52, 54, 56, 58 of transport section 14, unlike conventional conveyor systems, because sensors 74C detect the true position of the container anywhere along runs 52, 54, 56, 58 and send data to controller C indicating the container's true position. Further, the direct interaction between forcer 74 and reaction component 76' of the linear motor provide high fidelity control of the motion of the container. Accordingly, the controller C is capable of commanding the motor to stop the container precisely, and can accurately detect if the container is actually located at the precise location commanded. This is not possible with conventional conveyor systems, such as illustrated in Fig. 1A because of inaccuracies generated by the frictional drive system, susceptible to some slippage between container and drive, as well as variances in the conventional sensor system that in effect estimates container position between data points. For example, any deviation between the drive line, (aligned with the plane) of the roller in a conventional drive and the general direction of movement of the container will result in some slippage between drive roller and contact surface of the container. This in turn will generate a variance between rotation distance of the roller used to determine container position in the conventional system and actual travel of the container on the conveyor. Further slippage may occur during acceleration/deceleration increasing the margin of error between true position and calculated position in conventional systems. The conveyor runs 52, 54, 56, 58 of transport section 14 in Fig. 3 eliminate these problems of conventional systems. Construction tolerances due not influence the drive speed or accuracy in positioning the containers 151 on the conveyor runs. Maximum acceleration/deceleration rates can be achieved (unlike conventional systems where acceleration/deceleration rates are slip limited) thereby increasing efficiency of the transport section 14 and hence of the whole handling system. Moreover, controller C is capable of controlling forcer 74 to drive any desired number of containers along the conveyor run 56. Also the controller is capable of controlling the forcer 74 to move containers on the same conveyor run in opposite directions substantially at the same time. For example, as seen in Fig. 3, container 151 may be moved in direction X3 by the linear motor, while container 151A is being moved in direction X4.

The accuracy in controlling movement and placement of containers on conveyor runs 52, 54, 56, 58, allows any location on the conveyor runs to become a pick location O from which transport vehicle 200 can pick a container 15' off the conveyor runs. By way of example, and with reference again to Figs. 6A-6B, the transport vehicle 200 may be at a given position α on a track 22A of transport system section 12. For instance, the transport vehicle may be at location α having just released a container on conveyor run 56. Position α can be any position along track 22A. The vehicle hoist is shown in Figs. 6A-6B as being in the retracted position, though the hoist may be in its extended position (not shown) in which it can pick/release containers 151 from run 56. If in the extended position, the hoist 208 may be in the orientation shown in Fig. 6B, rotated 90° from that shown in Fig. 6A. In Fig. 6B, the gripper arms of the hoist are disposed astride the rails of the run 56. The controller C (see Fig. 2) controls the linear motor to bring a desired container 151 along run 56. The controller registers the position α of the transport vehicle 200 on track 22A and matches the position O of the container 151 so that the container is aligned, in this case under vehicle 200. Controller C controls position O on run 56 so that the vehicle hoist 208 may be merely extended to pick container 151 without further repositioning of the vehicle 200 on track 22A. In the case where the hoist 208 is extended (position E1 in Fig. 6B), the container is driven on run 56 to position O where the grip portion on the container 151 is between the gripping arms of the hoist 208. To effect the pick, the gripping arms of the hoist 208 are merely closed. This "drive in" capability provided by transport system section 14 greatly enhances the efficiency of handling system 10 by providing a maximum number of pick places on section 14. Although, the above has been described with respect to the vehicle 200 being in a static position α, a similar process may be used with the vehicle 200 in a dynamic position. In that case, the container 151 may be driven along run 56 to match both position and velocity with the vehicle 200 on track 22A.

As seen in Fig. 2, conveyor runs, for example runs 52, 56 of the transport system section 14, may be provided with shunts or run buffer sections 52B, 56B. The run buffer sections 52B, 56B are depicted schematically in Fig. 2, on one side of the conveyor runs, but may be located on either side of the runs. Fig. 5 shows a portion of a representative buffer section 56B on run 56. The buffer section has a support platform 90, which for example may be made from one or more rails 92. The support platform 90, intersects at least one of the conveyor run rails 660. The vertical flange 66V of the conveyor run rails 660 may be removed locally in way of platform 90. The support platform 90 may include omnidirectional supports such as ball bearings 93 (see Fig. 5) allowing the container 151 to move freely in any desired direction over the supports. The buffer section 56B may also include a suitable linear forcer component 94 capable of cooperating with the reaction elements 162, 164, 166, 168 on the container 151 (see Fig. 7) to move the container in the directions indicated by arrows X5, X6 in Fig. 5 into and out of the buffer section 56B. As can be realized from Figs. 5 and 7, the container 151 can be moved from the conveyor run 56 to the buffer section 56B and vice versa without reorienting the container. For example, in the orientation shown in Fig. 5, the container 151 is moved in direction X4 until substantially aligned with buffer section 56B. In that position, the reaction elements 164, 162 arranged to operate along axis B of the container, are capable of cooperating with the forcer 94. Hence, if desired, (such as in the case where a container is traveling in an opposite direction on conveyor run 56), the controller C (see also Fig. 2) activates forcer 94 to move container 151 in direction X5 into the buffer section 56B. When desired to return container 151 back to the conveyor run 56, forcer 94 is operated to move the container in direction X6 onto the rails 660, 66I. The container 151 can then be moved almost instantaneously thereafter in any desired direction along conveyor run 56. A similar approach is used to transit the containers at junctions between conveyor runs. In an alternate embodiment, any suitable type of junction device such as for example, using a turntable, may be used to di rect the container from the conveyor run into the buffer section. As can be realized from Fig. 5, the switching system enabling container transfer between conveyor run and buffer section is equally applicable to effecting transfer between any joining conveyor runs (see Fig. 2).

Still referring to Fig. 5, the buffer section 56B may be sized to hold as many containers 151 as desired. In the case of a one container buffer section, a single linear forcer component 94 may be provided with a pair of support rails 92. To expand the buffer section, additional linear forcer rails 94L and support rails 92L may be added in a general grid pattern as shown in Fig. 5. The pattern of outwardly extending rails 92, 94 and lateral extending rails 92L, 94L form the grid pattern which enables a container to move two dimensionally (in the directions indicated by arrows X5, X6, X7) to any location in the buffer section 56B. In Fig. 5, a single set of outward rails 92, 94 and a single set of lateral rails 92L, 94L is shown for example purposes. The rail pattern shown can be repeated as desired to provide a buffer section of any desired size.

Referring again to Fig. 3, mounting system 64 may include any suitable structural members to support the rails 660, 66I, 68 of the conveyor run 56 substantially under the track 23A of the corresponding interbay or intrabay transport branch. This allows the transport vehicles 200 on at least some portion of the tracks of the interbay or intrabay branches to pick or place containers 151 directly on the conveyor runs. Unlike conventional systems, the containers 151 an be placed by transport vehicles 200 on the conveyor runs at any time, and be moving on the conveyor runs immediately thereafter. Accordingly, seamless integration between the transport system section 12 and transport system section 14 (as no time is lost to coordinate between transport vehicles 200 on system section 12 on transport panels used in conventional conveyor systems). This in turn increases workpiece traveling density of the automated material handling system 10 and reliability (a defective container is readily removed from the system, and unlike a palletized system the impact is limited to only to that container without any loss in system transport capacity).

It should be understood that the foregoing description is only illustrative of the invention. Various alternatives and modifications can be devised by those skilled in the art without departing from the invention. Accordingly, the present invention is intended to embrace all such alternatives, modifications and variances which fall within the scope of the appended claims.

## Claims

1. A semiconductor work piece processing system comprising:
at least one processing tool (P) for processing semiconductor work pieces;
a container (151) for holding at least one semiconductor workpiece therein for transport to and from the processing tool (P);
a first transport section (12) connected to the processing tool (P) for transporting the container (151) to and from the processing tool (P); and
a second transport section (14) connected to the first transport section (12) for transporting the container (151) to and from the first transport section (12);
wherein the first transport section (12) is a vehicle based section having a transport vehicle (200) capable of holding the container (151) and moving along a first track (16) of the first transport section (12), and the second transport section (14) is a conveyor section and has a second track (18) with at least one support element (60) of the second track (18) adapted to interface with the container (151) for movably supporting the container (151) from the second track (18) and allowing the container (151) to move relative to the first track (16) and wherein the second transport section (14) has a motor (62) connected to the second track (18) for aligning the container (151) on the second track (18) with the transport vehicle (200) on the first track (16), **characterized in that** the first track (16) of the first transport section (12) is located substantially parallel to the second track (18) of the second transport section (14), and the first track (16) is arranged directly above the second track (18), wherein the first track (16) is arranged vertically above the second track (18), so that the transport vehicle (200) moves along the first track (16) arranged above the second transport section (14) which is a conveyor section.

2. The system according to claim 1, wherein the motor (62) is connected to the second track (18) for driving the container (151) along the second track (18), at least a portion (76;76') of the motor (62) being mounted to the container (151).

3. The system according to claim 2, wherein the container (151) has a one-piece frame assembly (154), the at least a portion (76;76') of the motor (62) being integral to the frame assembly (154) of the container (151).

4. The system according to claim 2, wherein at least a portion (76) of the motor (62) is molded in a portion (154L') of the frame assembly (154).

5. The system according to claim 2, wherein at least a portion (76') of the motor (62') is removably mounted to the frame assembly (154L').

6. The system according to claim 2, wherein at least another portion (68) of the motor (62) is fixedly connected to the track (18).

7. The system according to claim 2, wherein the motor (62) is a linear motor.

8. The system according to claim 2, wherein the motor (62) is a brushless motor.

9. The system according to claim 2, wherein the motor (62) is a solid state motor without moving parts.

10. The system according to claim 2, wherein the at least a portion (76; 76'; 76") of the motor (62) mounted to the container (151) includes a permanent magnet (162) mounted to the container (151).

11. The system according to claim 2, wherein the at least a portion (76) of the motor (62) mounted to the container (151) includes at least two permanent magnets (162, 166) the permanent magnets (162, 166) being arranged on the container (151) so that an axis (B) connecting poles of one (162) of the two magnets (162, 166) is oriented at an angle relative to another axis (A) connecting poles of another (168) of the two magnets (162, 168).

12. The system according to claim 2, wherein the motor (62) is adapted for bi-directionally driving the container (151) along the second track (18).

13. The system according to claim 2, wherein the motor (62) is adapted for bi-directionally driving the container (151) so that the container (151) is capable of moving bi-directionally along two different axes (A, B).

14. The system according to claim 13, wherein the two different axes (A, B) are crossing axes.

15. The system according to claim 1, wherein the second track (18) has a longitudinal portion (56) with at least one shunt portion (56B) extending laterally from the longitudinal portion (56).

16. The system according to claim 15, wherein the at least on e shunt portion (56B) provides for track buffering.

17. The system according to claim 1, wherein at least a portion of the first transport section (12) is disposed between the at least one processing tool (P) and the second transport section (14).

18. The system according to claim 1, wherein at least a portion of the second track (18) of the second transport section (14) extends substantially alongside a portion of the first track (16) of the first transport section (12).

19. The system according to claim 1, wherein at least a portion of the second track (18) of the second transport section (14) spans between at least two portions of the first track (16) of the first transport section (12).

20. The system according to claim 1, wherein the first track (16) and second track (18) are disposed proximate to each other to allow the container (151) to be moved therebetween in one move.

## Patentansprüche

1. Halbleiterwerkstück-Bearbeitungssystem, enthaltend:
mindestens ein Bearbeitungswerkzeug (P) zur Bearbeitung von Halbleiterwerkstücken;
einen Behälter (151) zur Aufnahme mindestens eines Halbleiterwerkstücks zum Transport von und zu dem Bearbeitungswerkzeug (P);
einen ersten Transportabschnitt (12), der mit dem Bearbeitungswerkzeug (P) für den Transport des Behälters (151) von und zu dem Bearbeitungswerkzeug (P) verbunden ist; und
einen zweiten Transportabschnitt (14), der mit dem ersten Transportabschnitt (12) verbunden ist, um den Behälter (151) zu und von dem ersten Transportabschnitt (12) zu transportieren;
wobei der erste Transportabschnitt (12) ein fahrzeugbasierter Abschnitt ist, der ein Transportfahrzeug (200) aufweist, das in der Lage ist, den Behälter (151) aufzunehmen und sich entlang einer ersten Bahn (16) des ersten Transportabschnitts (12) zu bewegen, und der zweite Transportabschnitt (14) ein Fördererabschnitt ist und eine zweite Bahn (18) hat, wobei mindestens ein Tragelement (60) der zweiten Bahn (18) für die Schnittstellenverbindung mit dem Behälter (151) ausgelegt ist, um den Behälter (151) von der zweiten Bahn (18) beweglich zu tragen und die Bewegung des Behälters (151) relativ zu der ersten Bahn (16) zu erlauben, und wobei der zweite Transportabschnitt (14) einen mit der zweiten Bahn (18) verbundenen Motor (62) hat, um den Behälter (151) auf der zweiten Bahn (18) mit dem Transportfahrzeug (200) auf der ersten Bahn (16) auszurichten, **dadurch gekennzeichnet, dass** die erste Bahn (16) des ersten Transportabschnitts (12) im Wesentlichen parallel zu der zweiten Bahn (18) des zweiten Transportabschnitts (14) angeordnet ist und die erste Bahn (16) direkt über der zweiten Bahn (18) angeordnet ist, wobei die erste Bahn (16) vertikal oberhalb der zweiten Bahn (18) angeordnet ist, so dass das Transportfahrzeug (200) sich entlang der ersten Bahn (16) bewegt, die oberhalb des zweiten Transportabschnitts (14) angeordnet ist, bei welchem es sich um einen Fördererabschnitt handelt.

2. System nach Anspruch 1, bei welchem der Motor (62) mit der zweiten Bahn (18) verbunden ist, um den Behälter (151) entlang der zweiten Bahn (18) anzutreiben, wobei ist wenigstens ein Teil (76; 76') des Motors (62) an dem Behälter (151) angebracht ist.

3. System nach Anspruch 2, bei welchem der Behälter (151) eine einstückige Rahmenanordnung (154) hat, wobei der wenigstens vorhandene Teil (76; 76') des Motors (62) mit der Rahmenanordnung (154) des Behälters (151) einstückig ist.

4. System nach Anspruch 2, bei welchem wenigstens ein Teil (76) des Motors (62) in einen Teil (154L') der Rahmenanordnung (154) eingeformt ist.

5. System nach Anspruch 2, bei welchem wenigstens ein Teil (76') des Motors (62') an der Rahmenanordnung (154L') abnehmbar angebracht ist.

6. System nach Anspruch 2, bei welchem wenigstens ein weiterer Teil (68) des Motors (62) mit der Bahn (18) fest verbunden ist.

7. System nach Anspruch 2, bei welchem der Motor (62) ein Linearmotor ist.

8. System nach Anspruch 2, bei welchem der Motor (62) ein bürstenloser Motor ist.

9. System nach Anspruch 2, bei welchem der Motor (62) ein Festkörpermotor ohne bewegliche Teile ist.

10. System nach Anspruch 2, bei welchem der an dem Behälter (151) angebrachte wenigstens eine Teil (76; 76'; 76") des Motors (62) einen an dem Behälter (151) angebrachten Permanentmagneten (162) umfasst.

11. System nach Anspruch 2, bei welchem der an dem Behälter (151) angebrachte wenigstens eine Teil (76; 76'; 76") des Motors (62) wenigstens zwei an dem Behälter (151) angebrachte Permanentmagnete (162, 166) umfasst, die an dem Behälter (151) so angeordnet sind, dass eine Achse (B), welche die Pole eines (162) der beiden Magnete (162, 166) verbindet, in einem Winkel zu einer anderen Achse (A) ausgerichtet ist, welche die Pole des anderen (168) der beiden Magnete (162, 168) verbindet.

12. System nach Anspruch 2, bei welchem der Motor (62) für den bidirektionalen Antrieb des Behälters (151) entlang der zweiten Bahn (18) ausgelegt ist.

13. System nach Anspruch 2, bei welchem der Motor (62) für den bidirektionalen Antrieb des Behälters (151) ausgelegt ist, so dass der Behälter (151) in der Lage ist, sich bidirektional entlang zwei verschiedenen Achsen (A, B) zu bewegen.

14. System nach Anspruch 13, bei welchem die beiden unterschiedlichen Achsen (A, B) sich kreuzende Achsen sind.

15. System nach Anspruch 1, bei welchem die zweite Bahn (18) einen länglichen Abschnitt (56) hat, wobei mindestens ein Nebenabschnitt (56B) seitlich von dem länglichen Abschnitt (56) verläuft.

16. System nach Anspruch 15, bei welchem der mindestens eine Nebenabschnitt (56B) eine Bahnpufferung bereitstellt.

17. System nach Anspruch 1, bei welchem mindestens ein Teil des ersten Transportabschnitts (12) zwischen dem mindestens einen Bearbeitungswerkzeug (P) und dem zweiten Transportabschnitt (14) angeordnet ist.

18. System nach Anspruch 1, bei welchem mindestens ein Teil der zweiten Bahn (18) des zweiten Transportabschnitts (14) im Wesentlichen entlang einem Teil der ersten Bahn (16) des ersten Transportabschnitts (12) verläuft.

19. System nach Anspruch 1, bei welchem mindestens ein Teil der zweiten Bahn (18) des zweiten Transportabschnitts (14) sich zwischen mindestens zwei Teilen der ersten Bahn (16) des ersten Transportabschnitts (12) erstreckt.

20. System nach Anspruch 1, bei welchem die erste Bahn (16) und die zweite Bahn (18) nahe aneinander angeordnet sind, um das Bewegen des Behälters (151) zwischen diesen in einer Bewegung zu erlauben.

## Revendications

1. Système de traitement de pièces semi-conductrices, comprenant :
au moins un outil de traitement (P) pour traiter des pièces semi-conductrices ;
un conteneur (151) pour y contenir au moins une pièce semi-conductrice pour le transport vers l'outil de traitement (P) et depuis celui-ci ;
une première section de transport (12) raccordée à l'outil de traitement (P) pour transporter le conteneur (151) vers l'outil de traitement (P) et depuis celui-ci ; et
une seconde section de transport (14) raccordée à la première section de transport (12) pour transporter le conteneur (151) vers la première section de transport (12) et depuis celle-ci ;
dans lequel la première section de transport (12) est une section motorisée ayant un véhicule de transport (200) capable de supporter le conteneur (151) et de le déplacer le long d'une première piste (16) de la première section de transport (12), et la seconde section de transport (14) est une section de transporteur et a une seconde piste (18) avec au moins un élément de support (60) de la seconde piste (18) adapté pour faire interface avec le conteneur (151) afin de supporter de manière mobile le conteneur (151) depuis la seconde piste (18) et de permettre au conteneur (151) de se déplacer par rapport à la première piste (16), et dans lequel la seconde section de transport (14) a un moteur (62) raccordé à la seconde piste (18) pour aligner le conteneur (151) sur la seconde piste (18) avec le véhicule de transport (200) sur la première piste (16), **caractérisé en ce que** la première piste (16) de la première section de transport (12) est placée de manière sensiblement parallèle à la seconde piste (18) de la seconde section de transport (14), et la première piste (16) est aménagée directement au-dessus de la seconde piste (18), dans lequel la première piste (16) est aménagée verticalement au-dessus de la seconde piste (18) de sorte que le véhicule de transport (200) se déplace le long de la première piste (16) aménagée au-dessus de la seconde section de transport (14) qui est une section de transporteur.

2. Système selon la revendication 1, dans lequel le moteur (62) est raccordé à la seconde piste (18) pour entraîner le conteneur (151) le long de la seconde piste (18), au moins une portion (76 ; 76') du moteur (62) étant montée sur le conteneur (151).

3. Système selon la revendication 2, dans lequel le conteneur (151) a un assemblage de châssis d'une seule pièce (154), la au moins une portion (76 ; 76') du moteur (62) faisant partie intégrante de l'assemblage de châssis (154) du conteneur (151).

4. Système selon la revendication 2, dans lequel la au moins une portion (76) du moteur (62) est moulée dans une portion (154L') de l'assemblage de châssis (154).

5. Système selon la revendication 2, dans lequel au moins une portion (76') du moteur (62') est montée de manière amovible sur l'assemblage de châssis (154L').

6. Système selon la revendication 2, dans lequel au moins une autre portion (68) du moteur (62) est raccordée de manière fixe à la piste (18).

7. Système selon la revendication 2, dans lequel le moteur (62) est un moteur linéaire.

8. Système selon la revendication 2, dans lequel le moteur (62) est un moteur sans balais.

9. Système selon la revendication 2, dans lequel le moteur (62) est un moteur à semi-conducteurs sans parties mobiles.

10. Système selon la revendication 2, dans lequel la au moins une portion (76 ; 76' ; 76") du moteur (62) montée sur le conteneur (151) comprend un aimant permanent (162) monté sur le conteneur (151).

11. Système selon la revendication 2, dans lequel la au moins une portion (76) du moteur (62) montée sur le conteneur (151) comprend au moins deux aimants permanents (162, 166), les aimants permanents (162, 166) étant aménagés sur le conteneur (151) de sorte qu'un axe (B) raccordant les pôles de l'un (162) des deux aimants (162, 166) soit orienté sous un certain angle par rapport à un autre axe (A) raccordant les pôles d'un autre (168) des deux aimants (162, 168).

12. Système selon la revendication 2, dans lequel le moteur (62) est adapté pour entraîner de manière bidirectionnelle le conteneur (151) le long de la seconde piste (18).

13. Système selon la revendication 2, dans lequel le moteur (62) est adapté pour entraîner de manière bidirectionnelle le conteneur (151) de sorte que le conteneur (151) soit capable de se déplacer de manière bidirectionnelle le long de deux axes différents (A, B).

14. Système selon la revendication 13, dans lequel les deux axes différents (A, B) sont des axes de croisement.

15. Système selon la revendication 1, dans lequel la seconde piste (18) a une portion longitudinale (56) avec au moins une portion de dérivation (56B) s'étendant latéralement de la portion longitudinale (56).

16. Système selon la revendication 15, dans lequel la au moins une portion de dérivation (56B) fournit un tampon de piste.

17. Système selon la revendication 1, dans lequel au moins une portion de la première section de transport (12) est disposée entre le au moins un outil de traitement (P) et la seconde section de transport (14).

18. Système selon la revendication 1, dans lequel au moins une portion de la seconde piste (18) de la seconde section de transport (14) s'étend sensiblement le long d'une portion de la première piste (16) de la première section de transport (12).

19. Système selon la revendication 1, dans lequel au moins une portion de la seconde piste (18) de la seconde section de transport (14) s'étend entre au moins deux portions de la première piste (16) de la première section de transport (12).

20. Système selon la revendication 1, dans lequel la première piste (16) et la seconde piste (18) sont disposées à proximité l'une de l'autre pour permettre au conteneur (151) de se déplacer entre elles en un seul mouvement.
